# EUROPEAN PATENT SPECIFICATION

(11) **EP 1 741 093 B1**
(45) Date of publication and mention of the grant of the patent: **25.05.2011**
(21) Application number: 05728310.3
(22) Date of filing: 21.03.2005
(51) Int. Cl.: G10L 19/00

(54) **SCALABLE LOSSLESS AUDIO CODEC AND AUTHORING TOOL**
SKALIERBARER VERLUSTLOSER AUDIO-CODEC UND ERSTELLUNGS-WERKZEUG
SYSTEME AUTEUR ET CODEC AUDIO, SANS PERTE ET EVOLUTIF

(30) Priority: 25.03.2004 US 556183 P; 04.08.2004 US 911062; 04.08.2004 US 911067
(43) Date of publication of application: 10.01.2007
(60) Divisional application: 10167970.2
(73) Proprietor: DTS, Inc., Calabasas, CA 91302 (US)
(72) Inventor: FEJZO, Zoran, Los Angeles, CA 90049 (US)
(74) Representative: Crawford, Andrew Birkby
(86) International application number: PCT/US2005/009240
(87) International publication number: WO 2005/098822

(56) References cited:
- EP-A- 0 869 620
- US-A1- 2003 179 938
- US-A1- 2003 179 938
- US-A1- 2003 231 799
- US-B1- 6 226 325
- US-B1- 6 226 325
- US-B1- 6 226 616
- US-B1- 6 385 571
- SANG-WOOK KIM ET AL: "Fine grain scalability in MPEG-4 Audio" CONVENTION PAPER 5491, 111TH CONVENTION, NEW YORK, NY, USA, 21 September 2001 (2001-09-21), XP002522956

## Description

### CROSS-REFERENCE TO RELATED APPLICATIONS

This application claims benefit of priority under 35 U.S.C. 119(e) to U.S. Provisional Application No. 60/566,183 entitled "Backward Compatible Lossless Audio Codec" filed on March 25, 2004.

### BACKGROUND OF THE INVENTION

### Field of the Invention

This invention relates to lossless audio codecs and more specifically to a scalable lossless audio codec and authoring tool.

### Description of the Related Art

Numbers of low bit-rate lossy audio coding systems are currently in use in a wide range of consumer and professional audio playback products and services. For example, Dolby AC3 (Dolby digital) audio coding system is a world-wide standard for encoding stereo and 5.1 channel audio sound tracks for Laser Disc, NTSC coded DVD video, and ATV, using bit rates up to 640kbit/s. MPEG I and MPEG II audio coding standards are widely used for stereo and multi-channel sound track encoding for PAL encoded DVD video, terrestrial digital radio broadcasting in Europe and Satellite broadcasting in the US, at bit rates up to 768kbit/s. DTS (Dig ital Theater Systems) Coherent Acoustics audio coding system is frequently used for studio quality 5.1 channel audio sound tracks for Compact Disc, DVD video, Satellite Broadcast in Europe and Laser Disc and bit rates up to 1536kbit/s.

An improved codec offering 96 kHz bandwidth and 24 bit resolution is disclosed in U.S. patent No. 6,226,616 (also assigned to Digital Theater Systems, Inc.). That patent employs a core and extension methodology in which the traditional audio coding algorithm constitutes the 'core' audio coder, and remains unaltered. The audio data necessary to represent higher audio frequencies (in the case of higher sampling rates) or higher sample resolution (in the case of larger word lengths), or both, is transmitted as an 'extension' stream. This allows audio content providers to include a single audio bit stream that is compatible with different types of decoders resident in the consumer equipment base. The core stream will be decoded by the older decoders which will ignore the extension data, while newer decoders will make use of both core and extension data streams giving higher quality sound reproduction. However, this prior approach does not provide truly lossless encoding or decoding. Although the system of U.S. patent 6,226,216 provides superior quality audio playback, it does not provide "lossless" performance.

Recently, many consumers have shown interest in these so-called "lossless" codecs. "Lossless" codecs rely on algorithms which compress data without discarding any information. As such, they do not employ psychoacoustic effects such as "masking". A lossless codec produces a decoded signal which is identical to the (digitized) source signal. This performance comes at a cost: such codecs typically require more bandwidth than lossy codecs, and compress the data to a lesser degree.

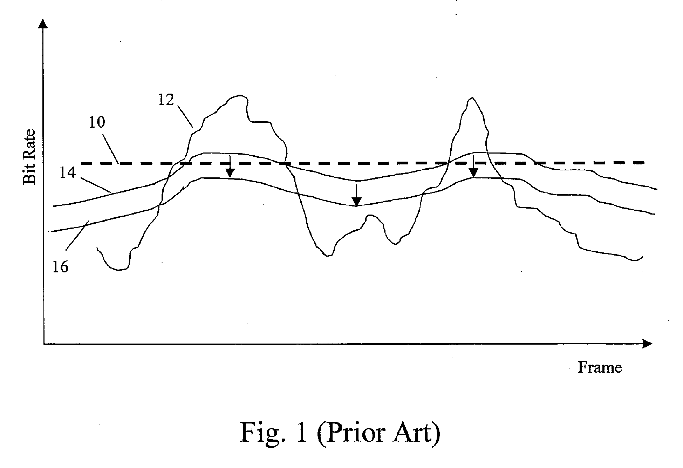

The lack of compression can cause a problem when content is being authored to a disk, CD, DVD, etc., particularly in cases of highly un-correlated source material or very large source bandwidth requirements. The optical properties of the media establish a peak bit rate for all content that can not be exceeded. As shown in Figure 1, a hard threshold 10, e.g., 9.6 Mbps for DVD audio, is typically established for audio so that the total bit rate does not exceed the media limit.

The audio and other data is laid out on the disk to satisfy the various media constraints and to ensure that all the data that is required to decode a given frame will be present in the audio decoder buffer. The buffer has the effect of smoothing the frame-to-frame encoded payload (bit rate) **12,** which can fluctuate wildly from frame-to-frame, to create a buffered payload **14,** i.e. the buffered average of the frame-to-frame encoded payload. If the buffered payload **14** of the lossless bitstream for a given channel exceeds the threshold at any point the audio input files are altered to reduce their information content. The audio files may be altered by reducing the bit-depth of one or more channels such as from 24-bit to 22-bit, filtering a channel's frequency bandwidth to low-pass only, or reducing the audio bandwidth such as by filtering information above 40 kHz when sampling at 96 kHz. The altered audio input files are re-encoded so that the payload **16** never exceeds the threshold **10.** An example of this process is described in the SurCode MLP - Owner's Manual pp. 20-23.

This is a very computationally and time inefficient process. Furthermore, although the audio encoder is still lossless, the amount of audio content that is delivered to the user has been reduced over the entire bitstream. Moreover, the alteration process is inexact, if too little information is removed the problem may still exist, if too much information is removed audio data is needlessly discarded. In addition, the authoring process will have to be tailored to the specific optical properties of the media and the buffer size of the decoder.

Publication EP0869620A2 refers to a digital data coding/decoding method and apparatus. This method includes analyzing the significance of the coded digital data and decoding the analyzed digital data from upper significant digits to the lower significance digits. Another publication US2003/179938A1 describes a method of forming a compressed signal in which a unit of two or more bits is split into a MSB part and an LSB part and where the MSB is compressed in a lossless fashion.

### SUMMARY OF THE INVENTION

The present invention provides an audio codec that generates a lossless bitstream and an authoring tool that selectively discards bits to satisfy media, channel, decoder buffer or playback device bit rate constraints without having to filter the audio input files, reencode or to otherwise disrupt the lossless bitstream.

This is accomplished, as claimed in the independent claims, by losslessly encoding the audio data in a sequence of analysis windows into a scalable bitstream, comparing the buffered payload to an allowed payload for each window, and selectively scaling the losslessly encoded audio data in the non-conforming windows to reduce the encoded payload, hence the buffered payload thereby introducing loss.

In an exemplary embodiment, the audio encoder separates the audio data into most significant bit (MSB) and least significant bit (LSB) portions and encodes each with a different lossless algorithm. An authoring tool writes the MSB portions to a bitstream, writes the LSB portions in the conforming windows to the bitstream, and scales the lossless LSB portions of any non-conforming frames to make them conform and writes the now lossy LSB portions to the bitstream. The audio decoder decodes the MSS and LSB portions and reassembles the PCM audio data.

The audio encoder splits each audio sample into the MSB and LSB portions, encodes the MSB portion with a first lossless algorithm, encodes the LSB portion with a second lossless algorithm, and packs the encoded audio data into a scalable, lossless bitstream. The boundary point between the MSB and LSB portions is suitably established by the energy and/or maximum amplitude of samples in an analysis window. The LSB bit widths are packed into the bitstream. The LSB portion is preferably encoded so that some or all of the LSBs may be selectively discarded. Frequency extensions may be similarly encoded with MSB/LSB or entirely encoded as LSBs.

An authoring tool is used to lay out the encoded data on a disk (media). The initial layout corresponds to the buffered payload. The tool compares the buffered payload to the allowed payload for each analysis window to determine whether the layout requires any modification. If not, all of the lossless MSB and LSB portions of the lossless bitstream are written to a bitstream and recorded on the disk. If yes, the authoring tool scales the lossless bitstream to satisfy the constraints. More specifically, the tool writes the lossless MSB and LSB portion for all of the conforming windows and the headers and lossless MSB portions for the non-conforming to a modified bitstream. Based on a prioritization rule, for each non-conforming window the authoring tool then determines how many of the LSBs to discard from each audio sample in the analysis window for one ore more audio channels and repacks the LSB portions into the modified bitstream with their modified bit widths. This is repeated for only those analysis windows in which the buffered payload exceeds the allowed payload.

A decoder receives the authored bitstream via the media or transmission channel. The audio data is directed to a buffer, which does not overflow on account of the authoring, and in turn provides sufficient data to a DSP chip to decode the audio data for the current analysis window. The DSP chip extracts the header information and extracts, decodes and assembles the MSB portions of the audio data. If all of the LSBs were discarded during authoring, the DSP chip translates the MSB samples to the original bit width word and outputs the PCM data. Otherwise, the DSP chip decodes the LSB portions, assembles the MSB & LSB samples, translates the assembled samples to the original bit width word and outputs the PCM data.

These and other features and advantages of the invention will be apparent to those skilled in the art from the following detailed description of preferred embodiments, taken together with the accompanying drawings, in which:

### BRIEF DESCRIPTION OF THE DRAWINGS

FIG. 1, as described above, is a plot of bit rate and payload for a lossless audio channel versus time;
FIG. 2 is a block diagram of a lossless audio codec and authoring tool in accordance with the present invention;
FIG. 3 is a simplified flowchart of the audio coder;
FIG. 4 is a diagram of an MSB/LSB split for a sample in the lossless bitstream;
FIG. 5 is a simplified flowchart of the authoring tool;
FIG. 6 is a diagram of an MSB/LSB split for a sample in the authored bitstreams;
FIG. 7 is a diagram of a bitstream including the MSB and LSB portions and header information;
FIG. 8 is a plot of payload for the lossless and authored bitstreams;
FIG. 9 is a simple block diagram of an audio decoder;
FIG. 10 is a flowchart of the decoding process;
FIG. 11 is a diagram of an assembled bitstream;
FIGs. 12-15 illustrate the bitstream format, encoding, authoring, and decoding for a particular embodiment; and
FIGs. 16a and 16b are block diagrams of the encoder and decoder for a scalable lossless codec that is backwards compatible with a lossy core encoder.

### DETAILED DESCRIPTION OF THE INVENTION

The present invention provides a lossless audio codec and authoring tool for selectively discarding bits to satisfy media, channel, decoder buffer or playback device bit rate constraints without having to filter the audio input files, reencode or to otherwise disrupt the lossless bitstream.

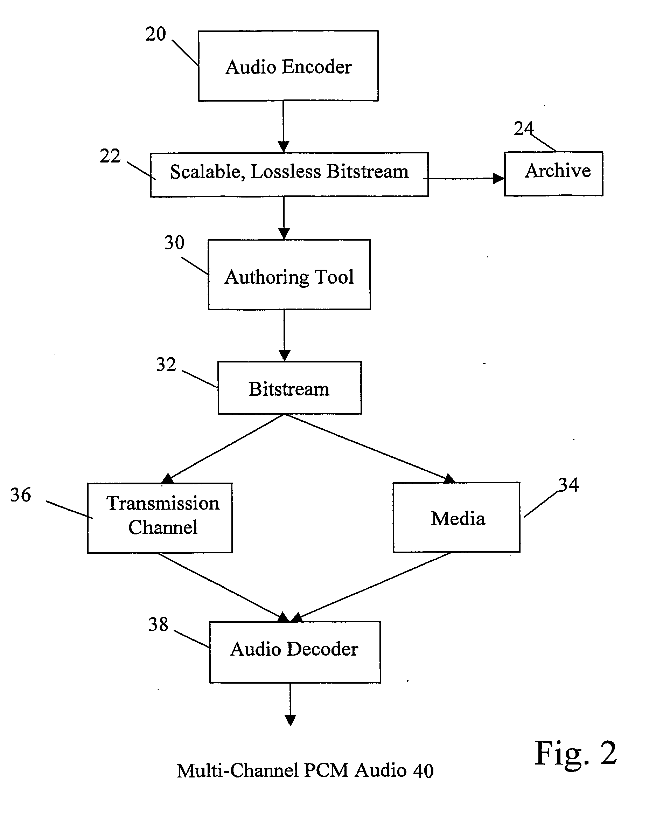

As shown in Figure 2, an audio encoder **20** losslessly encodes the audio data in a sequence of analysis windows and packs the encoded data and header information into a scalable, lossless bitstream **22,** which is suitably stored in an archive **24.** The analysis windows are typically frames of encoded data but as used herein the windows could span a plurality of frames. Furthermore, the analysis window may be refined into one or more segments of data inside a frame, one or more channel sets inside a segment, one or more channels in each channel set and finally one or more frequency extensions inside a channel. The scaling decisions for the bitstream can be very coarse (multiple frames) or more refined (per frequency extension per channel set per frame).

An authoring tool 30 is used to lay out the encoded data on a disk (media) in accordance with the decoder's buffer capacity. The initial layout corresponds to the buffered payload. The tool compares the buffered payload to the allowed payload for each analysis window to determine whether the layout requires any modification. The allowed payload is typically a function of the peak bit rate supported by a media (DVD disk) or transmission channel. The allowed payload may be fixed or allowed to vary if part of a global optimization. The authoring tool selectively scales the losslessly encoded audio data in the non-conforming windows to reduce the encoded payload, hence the buffered payload. The scaling process introduces some loss into the encoded data but is confined to only the non-conforming windows and is suitably just enough to bring each window into conformance. The authoring tool packs the lossless and lossy data and any modified header information into a bitstream **32.** The bitstream **32** is typically stored on a media **34** or transmitted over a transmission channel **36** for subsequent playback via an audio decoder **38**, which generates a single or multi-channel PCM (pulse code modulated) audio stream **40.**

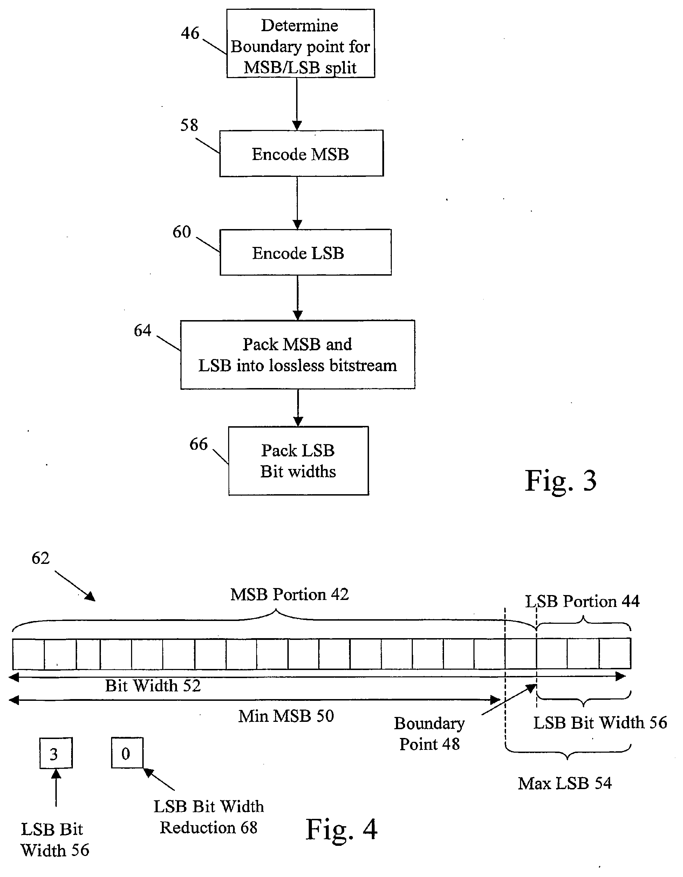

In an exemplary embodiment as shown in Figures 3 and 4, the audio encoder **20** splits each audio sample into a MSB portion **42** and a LSB portion **44** (step **46**). The boundary point **48** that separates the audio data is computed by first assigning a minimum MSB bit width (Min MSB) **50** that establishes a minimum coding level for each audio sample. For example, if the bit width **52** of the audio data is 20-bit the Min MSB might be 16-bit. It follows that the maximum LSB bit width (Max LSB) **54** is the Bit Width **52** minus the Min MSB **50.** The encoder computes a cost function, e.g. the L₂ or L_{∞} norms, for the audio data in the analysis window. If the cost function exceeds a threshold, the encoder calculates an LSB bit width **56** of at least one bit and no more than Max LSB. If the cost function does not exceed the threshold, the LSB bit width **56** is set to zero bits. In general, the MSB/LSB split is done for each analysis window. As describe above, this is typically one or more frames. The split can be further refined for each data segment, channel set, channel or frequency extension, for example. More refinement improves coding performance at the cost of additional computations and more overhead in the bitstream.

The encoder losslessly encodes the MSB portions (step **58**) and LSB portions (step **60**) with different lossless algorithms. The audio data in the MSB portions is typically highly correlated both temporally within any one channel and between channels. Therefore, the lossless algorithm suitably employs entropy coding, fixed prediction, adaptive prediction and joint channel decorrelation techniques to efficiently code the MSB portions. A suitable lossless encoder is described in copending application "Lossless Multi-Channel Audio Codec" filed on August 08, 2004, serial number 10/911067, which is hereby incorporated by reference. Other suitable lossless encoders include MLP (DVD Audio), Monkey's audio (computer applications), Apple lossless, Windows Media Pro lossless, AudioPak, DVD, LTAC, MUSICcompress, OggSquish, Philips, Shorten, Sonarc and WA. A review of many of these codecs is provided by Mat Hans, Ronald Schafer "Lossless Compression of Digital Audio" Hewlett Packard, 1999.

Conversely, the audio data in the LSB portion is highly uncorrelated, closer to noise. Therefore sophisticated compression techniques are largely ineffective and consume processing resources. Furthermore, to efficiently author the bitstream, a very simple lossless code using simplistic prediction of very low order followed by a simple entropy coder is highly desirable. In fact, the currently preferred algorithm is to encode the LSB portion by simply replicating the LSB bits as is. This will allow individual LSBs to be discarded without having to decode the LSB portion.

The encoder separately packs the encoded MSB and LSB portions into a scalable, lossless bitstream **62** so that they can be readily unpacked and decoded (step **64**). In addition to the normal header information, the encoder packs the LSB bit width **56** into the header (step **66**). The header also includes space for an LSB bit width reduction **68**, which is not used during encode. This process is repeated for each analysis window (frames, frame, segment, channel set or frequency extension) for which the split is recalculated.

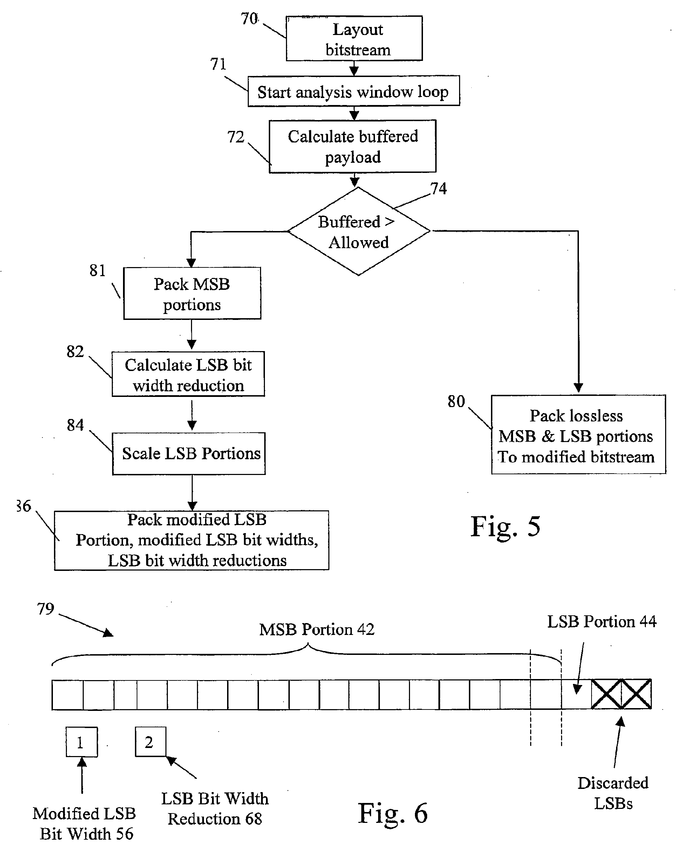

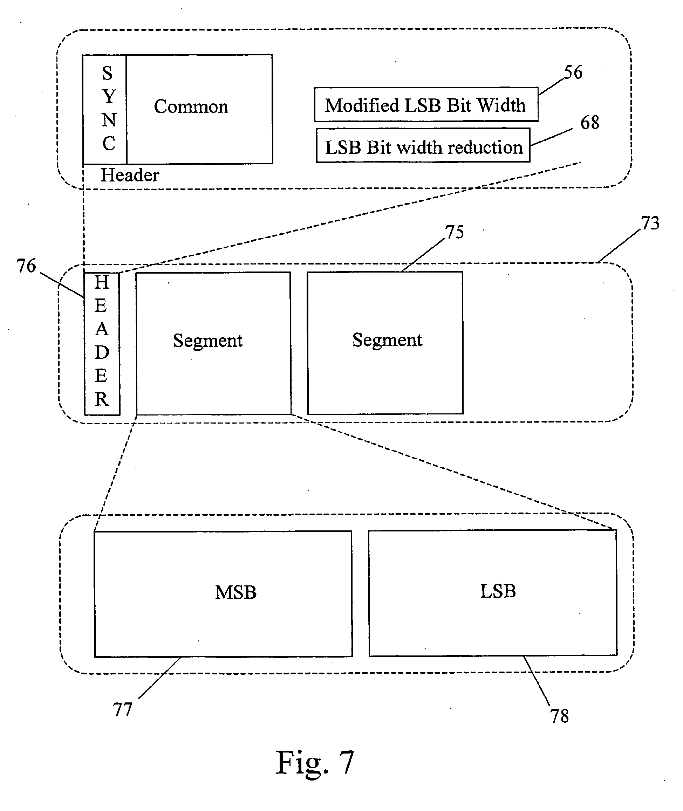

As shown in Figures 5, 6 and 7, the authoring tool **30** allows a user to make a first pass at laying out the audio and video bitstreams on the media in accordance with the decoder's buffer capacity (step **70**) to satisfy the media's peak bit rate constraint. The authoring tool starts the analysis window loop (step **71**), calculates an buffered payload (step **72**) and compares the buffered payload to the allowed payload for the analysis window **73** to determine whether the lossless bitstream requires any scaling to satisfy the constraints (step **74**). The allowed payload is determined by buffer capacity of the audio decoder and the peak bit rate of the media or channel. The encoded payload is determined by the bit width of the audio data and the number of samples in all of the data segments **75** plus the header **76.** If the allowed payload is not exceeded, the losslessly encoded MSB and LSB portions are packed into respective MSB and LSB areas **77** and **78** of the data segments **75** in a modified bitstream 79 (step **80**). If the allowed payload is never exceeded, the lossless bitstream is transferred directly to the media or channel.

If the buffered payload exceeds the allowed payload, the authoring tool packs the headers and losslessly encoded MSB portions **42** into the modified bitstream **79** (step **81**). Based on a prioritization rule, the authoring tool calculates an LSB bit width reduction **68** that will reduce the encoded payload, hence buffered payload to at most the allowed payload (step **82**). Assuming the LSB portions were simply replicated during lossless encoding, the authoring tool scales the LSB portions (step **84)** by preferably adding dither to each LSB portion so as to dither the next LSB bit past the LSB bit width reduction, and then shifting the LSB portion to the right by the LSB bit width reduction to discard bits. If the LSB portions were encoded, they would have to be decoded, dithered, shifted and reencoded. The tool packs the now lossy encoded LSB portions for the now conforming windows into the bitstream with the modified LSB bit widths **56** and the LSB bit width reduction **68** and a dither parameter (step **86**).

As shown in Figure 6, the LSB portion **44** has been scaled from a bit width of 3 to a modified LSB bit width **56** of 1-bit. The two discarded LSBs **88** match the LSB bit width reduction **68** of 2 bits. In the exemplary embodiment, the modified LSB bit width **56** and LSB bit width reduction **68** are transmitted in the header to the decoder. Alternately, either of these could be omitted and the original LSB bit width transmitted. Any one of the parameters is uniquely determined by the other two.

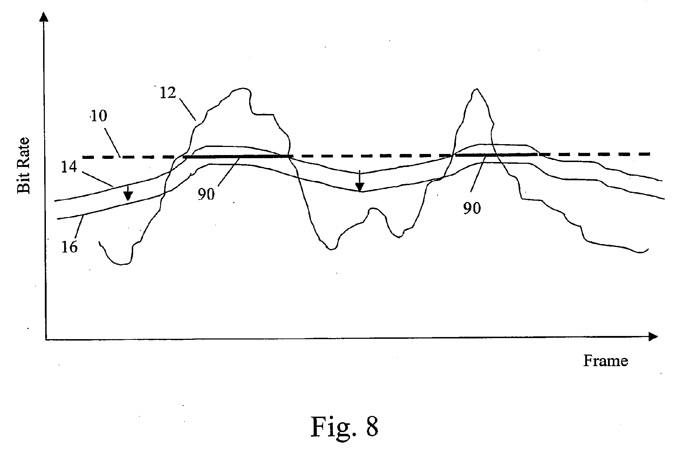

The benefits of the scalable, lossless encoder and authoring tool are best illustrated by overlaying the buffered payload **90** for the authored bitstream on Figure 1 as is done in Figure 8. Using the known approach of altering the audio files to remove content and then simply reencoding with the lossless coder, the buffered payload **14** was effectively shifted downward to a buffered payload **16** that is less than the allowed payload **10.** To ensure that the peak payload is less than the allowed payload, a considerable amount of content is sacrificed across the entire bitstream. By comparison, the buffered payload **90** replicates the original losslessly buffered payload **14** except in those few windows (frames) where the buffered payload exceeds the allowed payload. In these areas, the encoded payload, hence buffered payload is reduced just enough to satisfy the constraint and preferably no more. As a result, the payload capacity is utilized more efficiently and more content is delivered to the end user without having to alter the original audio files or reencode.

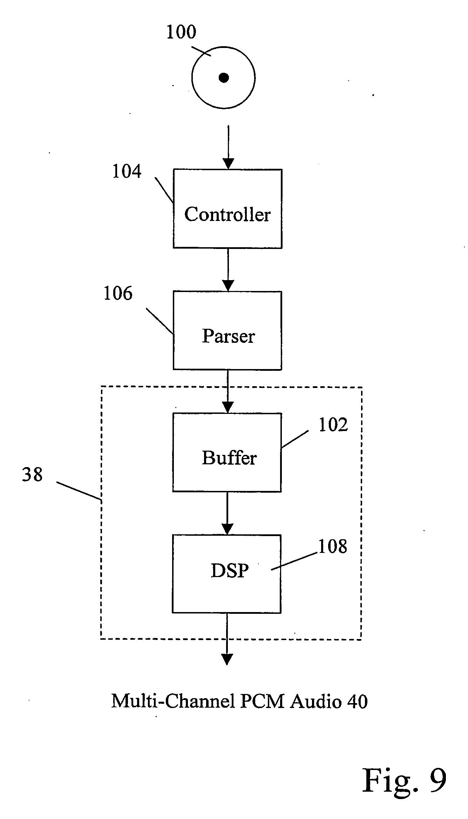

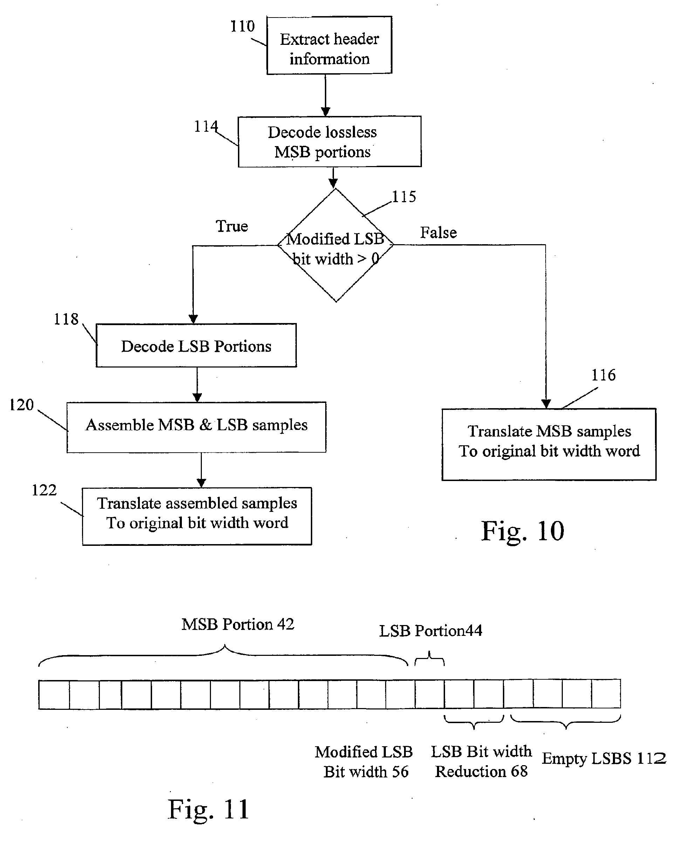

As shown in Figures 9, 10 and 11, the audio decoder **38** receives an authored bitstream via a disk **100.** The bitstream is separated into a sequence of analysis windows, each including header information and encoded audio data. Most of the windows include losslessly encoded MSB and LSB portions, the original LSB bit widths and LSB bit width reductions of zero. To satisfy the payload constraints set by the peak bit rate of the disk 100 and the capacity of the buffer **102,** some of the windows include the losslessly encoded MSB portions and lossy LSB portions, the modified bit widths of the lossy LSB portions, and the LSB bit width reductions.

A controller **104** reads the encoded audio data from the bitstream on the disk **100.** A parser **106** separates the audio data from the video and streams the audio data to the audio buffer **102,** which does not overflow on account of the authoring. The buffer in turn provides sufficient data to a DSP chip **108** to decode the audio data for the current analysis window. The DSP chip extracts the header information (step **110**) including the modified LSB bit widths **56,** LSB bit width reduction **68,** a number of empty LSBs **112** from an original word width and extracts, decodes and assembles the MSB portions of the audio data (step **114**)**.** If all of the LSBs were discarded during authoring or original LSB bit width was 0 (step **115**), the DSP chip translates the MSB samples to the original bit width word and outputs the PCM data (step **116**). Otherwise, the DSP chip decodes the lossless and lossy LSB portions (step **118**), assembles the MSB & LSB samples (step **120**), and, using the header information, translates the assembled samples to the original bit width word (step **122**).

### Multi-Channel Audio Codec & Authoring Tool

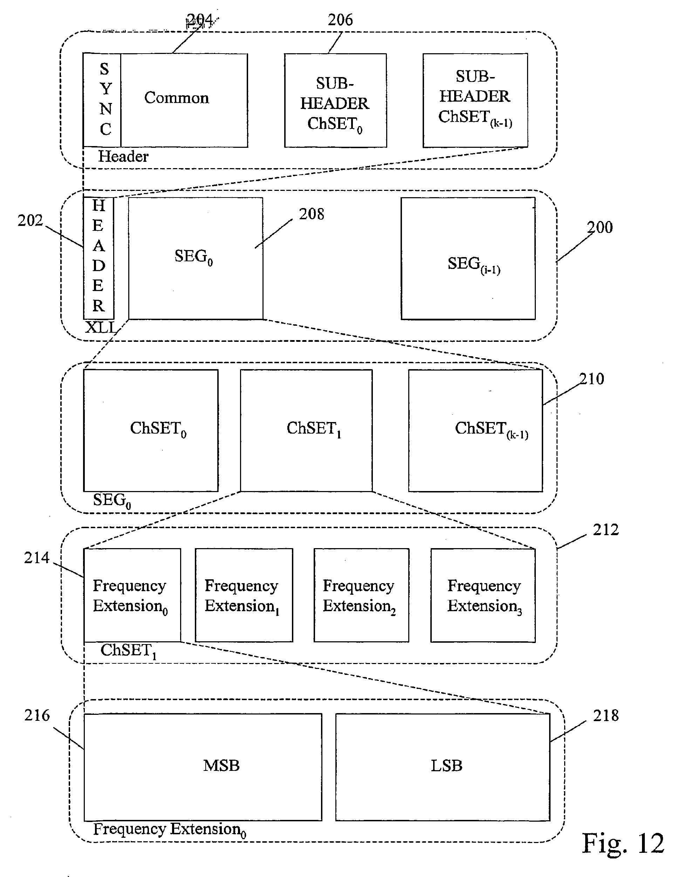

An exemplary embodiment of an audio codec and authoring tool for an encoded audio bitstream presented as a sequence of frames is illustrated in Figures 12-15. As shown in Figure 12, each frame **200** comprises a header **202** for storing common information **204** and sub-headers **206** for each channel set that store the LSB bit widths and LSB bit width reductions, and one or more data segments **208.** Each data segment comprises one or more channel sets **210** with each channel set comprising one or more audio channels **212.** Each channel comprises one or more frequency extensions **214** with at least the lowest frequency extension including encoded MSB and LSB portions **216, 218.** The bitstream has a distinct MSB and LSB split for each channel in each channel set in each frame. The higher frequency extensions may be similarly split or entirely encoded as LSB portions.

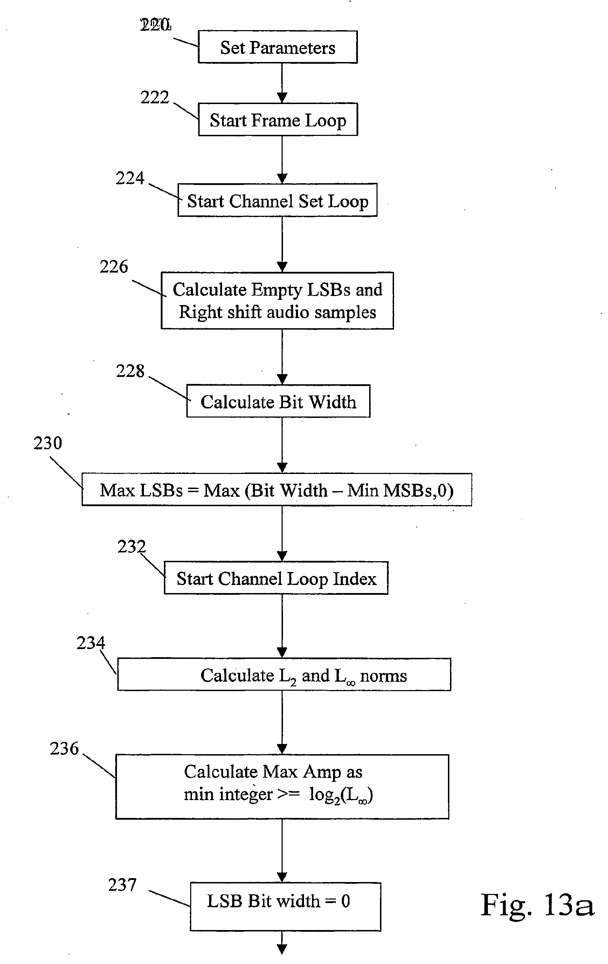

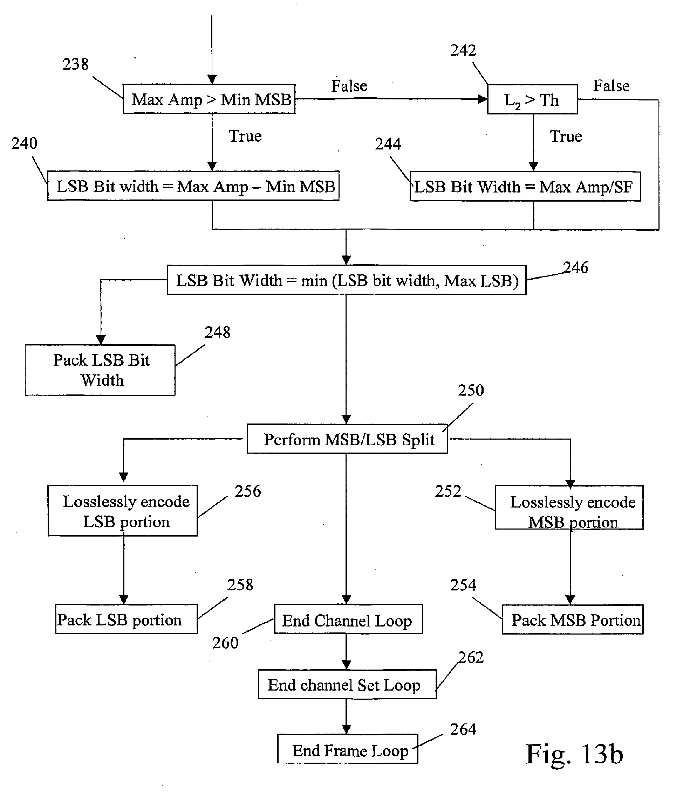

The scalable lossless bitstream from which this bitstream is authored is encoded as illustrated in Figures 13a and 13b. The encoder sets the bit width of the original word (24-bit), the Min MSB (16-bit), a threshold (Th) for the squared L2 norm and a scale factor (SF) for that norm (step **220**). The encoder starts the frame loop (step **222**) and the channel set loop (step **224**). Because the actual width of the audio data (20-bit) may be less than the original word width, the encoder calculates the number of empty LSBs (24-20=4)(min number of "0" LSBs in any PCM sample in the current frame) and right shifts every sample by that amount (step **226**)**.** The bit width of the data is the original bit width (24) minus the number of empty LSBs (4). (step **228**)**.** The encoder then determines the maximum number of bits (Max LSBs) that will allow to be encoded as part of the LSB portion as Max(Bit Width- Min MSB, 0) (step **230**). In the current example, the Max LSBS = 20- 16 = 4 bits.

To determine the boundary point for splitting the audio data into MSB and LSB portions, the encoder starts the channel loop index (step **232)** and calculates the L_{∞} norm as the maximum absolute amplitude of the audio data in the channel and the squared L2 norm as the sum of the squared amplitudes of the audio data in the analysis window (s tep **234).** The encoder sets a parameter Max Amp as the minimum integer greater than or equal to log₂ (L_{∞}) (step **236)** and initializes the LSB bit width to zero (step **237).** If the Max Amp is greater than the Min MSB (step **238**), the LSB bit width is set equal to the difference of the Max Amp and Min MSB (step **240).** Otherwise, if the L2 norm exceeds the Threshold (small amplitude but considerable variance) (step **242),** the LSB bit width is set equal to the Max Amp divided by the Scale Factor, typically > 1 (step **244).** If both tests are false, the LSB bit width remains zero. In other words, to maintain the minimum encode quality, e.g. Min MSB, no LSBs are available. The encoder clips the LSB bit width at the Max LSB value (step **246)** and packs the value into the sub-header channel set (step **248).**

Once the boundary point has been determined, i.e. the LSB bit width, the encoder splits the audio data into the MSB and LSB portions (step **250).** The MSB portion is losslessly encoded using a suitable algorithm (step **252)** and packed into the lowest frequency extension in the particular channel in the channel set of the current frame (step **254).** The LSB portion is losslessly encoded using a suitable algorithm, e.g. simple bit replication (step **256**) and packed (step **258**).

This process is repeated for each channel (step **260)** for each channel set (step **262)** for each frame (step **264)** in the bitstream. Furthermore, the same procedure may be repeated for higher frequency extensions. However, because these extensions contain much less information, the Min MSB may be set to 0 so that it is all encoded as LSBs.

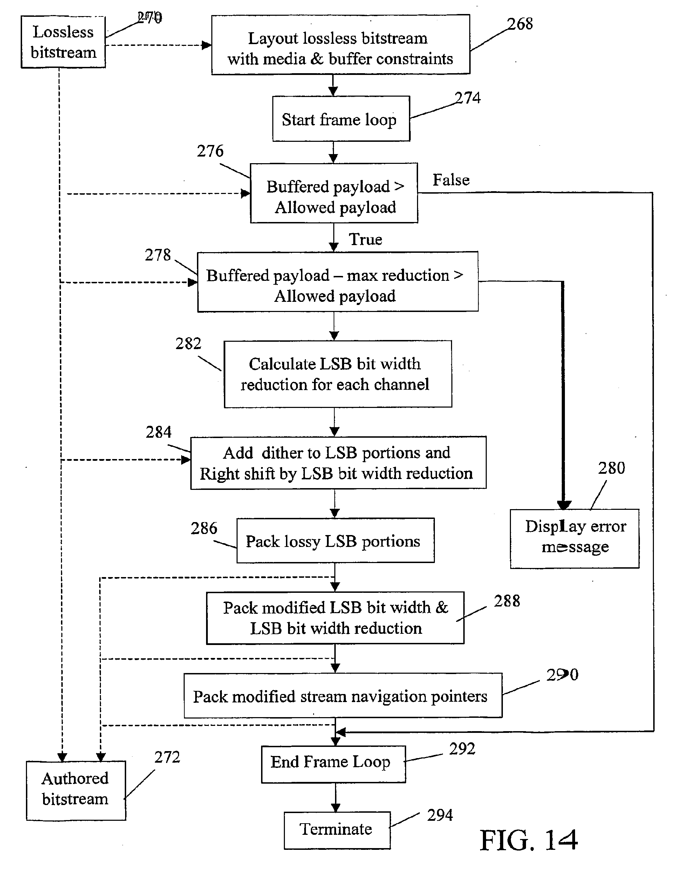

Once the scalable lossless bitstream is encoded for certain audio content, an authoring tool creates the best bitstream it can that satisfies the peak bit rate constraints of the transport media and the capacity of the buffer in the audio decoder. As shown in Figure 14, a **user** attempts to layout the lossless bitstream **268** on the media to conform to the bit rate and buffer capacity constrains (step **270**). If successful, the lossless bitstream **268** is written out as the authored bitstream **272** and stored on the media. Otherwise the authoring tool starts the frame loop (step **274**) and compares the buffered payload (buffered average frame-to-frame payload) to the allowed payload (peak bit rate) (step **276**). If the current frame conforms to the allowed payload, the losslessly encoded MSB and LSB portions are extracted from the lossless bitstream **268** and written to the authored bitstream **272** and the frame is incremented.

If the authoring tool encounters a non-conforming frame in which the buffered payload exceeds the allowed payload, the tool computes the maximum reduction that can be achieved by discarding all of the LSB portions in the channel set and subtracts it from the buffered payload (step **278**)**.** If the minimum payload is still too big the tool displays an error message that includes the amount of excess date and frame number (step **280**). In this case either the Min MSB shall be reduced or the original audio files shall be altered and re-encoded.

Otherwise, the authoring tool calculates an LSB bit width reduction for each channel in the current frame based on a specified channel prioritization rule (step **282**) such that:
Bit Width Reduction[nCh] < LSB bit width [nCh] for nCh = 0, ... AllChannels -1, and
Buffered payload[nFr] - ∑ (Bit Width Reduction[nCh} * NumSamplesin Frame) < Allowed Payload [nFr]

The reduction of the LSB bit widths by these values will ensure that the frame conforms to the allowed payload. This is done with a minimum amount of loss being introduced into the non-conforming frames and without otherwise affecting the lossless conforming frames.

The authoring tool adjusts the encoded LSB portions (assuming bit replication encoding) for each channel by adding dither to each LSB portion in the frame to dither the next bit and then right shifting by the LSB bit width reduction (step **284**). Adding dither is not necessary but is, highly desirable in order to decorrelate the quantization errors and also make them decorrelated from the original audio signal. The tool packs the now lossy scaled LSB portions (step **286**), the modified LSB bit widths and LSB bit width reductions for each channel (step **288**) and the modified stream navigation points (step **290**) into the authored bitstream. If dither is added, a dither parameter is packed into the bitstream. This process is then repeated for each frame (step **292**) before terminating (step **294**).

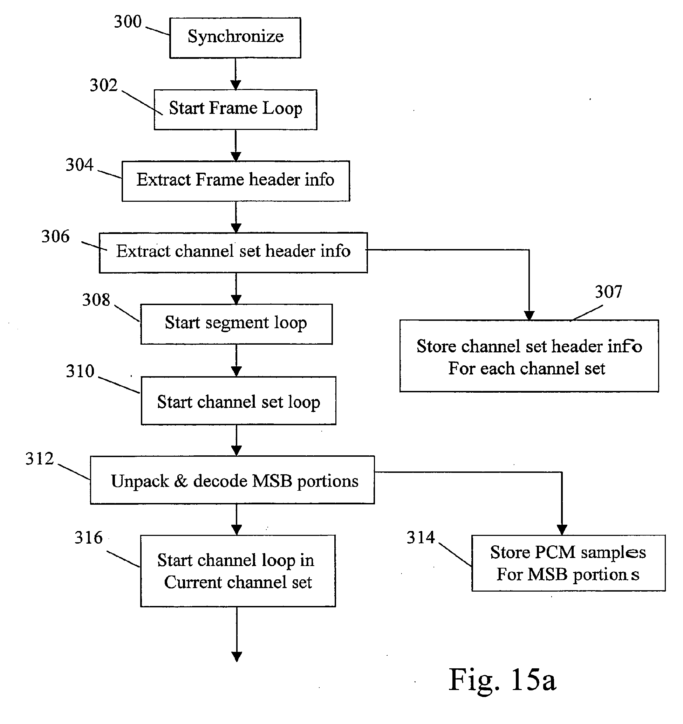

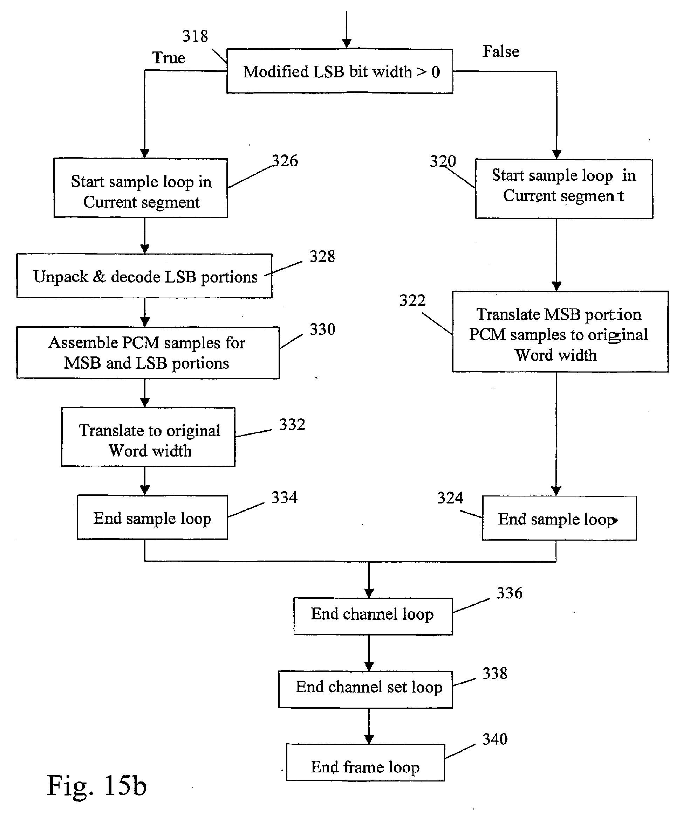

As shown in Figures 15a and 15b, a suitable decoder synchronizes to the bitstream (step **300**) and starts a frame loop (step **302**)**.** The decoder extracts the frame header information including the number of segments, number of samples in a segment, number of channel sets, etc (step **304**) and extracts the channel set header information including the number channels in the set, number of empty LSBs, LSB bit width, LSB bit width reduction for each channel set (step **306**) and stores it for each channel set (step **307**).

Once the header information is available, the decoder starts the segment loop (step **308)** and channel set loop (step **310**) for the current frame. The decoder unpacks and decodes the MSB portions (step **312**) and stores the PCM samples (step **314**). The decoder then starts the channel loop in the current channel set (step **316**) and proceeds with the encoded LSB data.

If the modified LSB bit width does not exceed zero (step **318**), the decoder starts the sample loop in the current segment (step **320**), translates the PCM samples for the MSB portion to the original word width (step **322**) and repeats until the sample loop terminates (step **324**).

Otherwise, the decoder starts the sample loop in the current segment (step **326**), unpacks and decodes the LSB portions (step **328**) and assembles PCM samples by appending the LSB portion to the MSB portion (step **330**). The decoder then translates the PCM sample to the original word width using the empty LSB, modified LSB bit width and LSB bit width reduction information from the header (step **332**) and repeats the steps until the sample loop terminates (step **334**). To reconstruct the entire audio sequence, the decoder repeats these steps for each channel (step **336**) in each channel set (step **338)** in each frame (step **340**)**.**

### Backward Compatible Scalable Audio Codec

The scalability properties can be incorporated into a backward compatible lossless encoder, bitstream format and decoder. A "lossy" core code stream is packed in concert with the losslessly encoded MSB and LSB portions of the audio data for transmission (or recording). Upon decoding in a decoder with extended lossless features, the lossy and lossless MSB streams are combined and the LSB stream is appended to construct a lossless reconstructed signal. In a prior-generation decoder, the lossless MSB and LSB extension streams are ignored, and the core "lossy" stream is decoded to provide a high-quality, multichannel audio signal with the bandwidth and signal-to-noise ratio characteristic of the core stream.

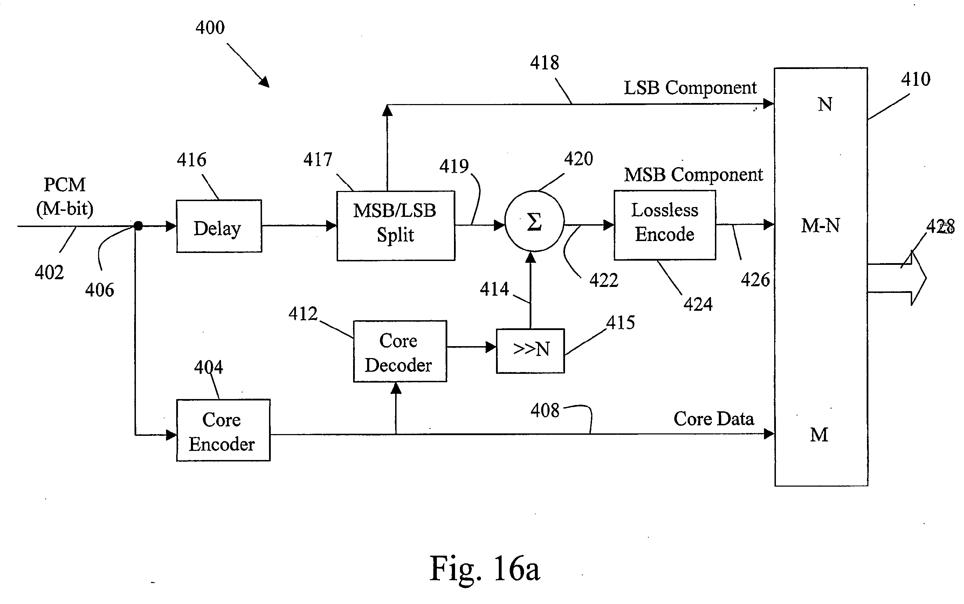

Figure 16a shows a system level view of a scalable backward compatible encoder **400.** A digitized audio signal, suitably M-bit PCM audio samples, is provided at input **402.** Preferably, the digitized audio signal has a sampling rate and bandwidth which exceeds that of a modified, lossy core encoder **404.** In one embodiment, the sampling rate of the digitized audio signal is 96 kHz (corresponding to a bandwidth of 48 kHz for the sampled audio). It should also be understood that the input audio may be, and preferably is, a multichannel signal wherein each channel is sampled at 96 kHz. The discussion which follows will concentrate on the processing of a single channel, but the extension to multiple channels is straightforward. The input signal is duplicated at node **406** and handled in parallel branches. In a first branch of the signal path, a modified lossy, wideband encoder **404** encodes the signal. The modified core encoder **404,** which is described in detail below, produces an encoded data stream (corestream **408**) which is conveyed to a packer or multiplexer **410.** The corestream **408** is also communicated to a modified corestream decoder **412,** which produces as output a modified, reconstructed core signal **414,** which is right shifted by N bits (»N **415**) to discard its N lsbs.

Meanwhile, the input digitized audio signal **402** in the parallel path undergoes a compensating delay **416,** substantially equal to the delay introduced into the reconstructed audio stream (by modified encode and modified decoders), to produce a delayed digitized audio stream. The audio stream is split into MSB and LSB portions **417** as described above. The N-bit LSB portion **418** is conveyed to the packer **410.** The M-N bit reconstructed core signal **414,** which was shifted to align with the MSB portion, is subtracted from the MSB portion of the delayed digitized audio stream **419** at subtracting node **420.** (Note that a summing node could be substituted for a subtracting node, by changing the polarity of one of the inputs. Thus, summing and subtracting may be substantially equivalent for this purpose).

Subtracting node **420** produces a difference signal **422** which represents the difference between the M-N MSBs of the original signal and the reconstructed core signal. To accomplish purely "lossless" encoding, it is necessary to encode and transmit the difference signal with lossless encoding techniques. Accordingly, the M-N bit difference signal **422** is encoded with a lossless encoder **424,** and the encoded M-N bit signal **426** packed or multiplexed with the core stream **408** in packer **410** to produce a multiplexed output bitstream **428.** Note that the lossless coding produced coded lossless streams **418** and **426** which are at a variable bit rate, to accommodate the needs of the lossless coder. The packed stream is then optionally subjected to further layers of coding including channel coding, and then transmitted or recorded. Note that for purposes of this disclosure, recording may be considered as transmission through a channel.

The core encoder **404** is described as "modified" because in an embodiment capable of handling extended bandwidth the core encoder would require modification. A 64-band analysis filter bank within the encoder discards half of its output data and encodes only the lower 32 frequency bands. This discarded information is of no concern to legacy decoders that would be unable to reconstruct the upper half of the signal spectrum in any case. The remaining information is encoded as per the unmodified encoder to form a backwards-compatible core output stream. However, in another embodiment operating at or below 48 kHz sampling rate, the core encoder could be a substantially unmodified version of a prior core encoder. Similarly, for operation above the sampling rate of legacy decoders, the core decoder **412** would need to be modified as described below. For operation at conventional sampling rate (e.g., 48 kHz and below) the core decoder could be a substantially unmodified version of a prior core decoder or equivalent. In some embodiments the choice of sampling rate could be made at the time of encoding, and the encode and decode modules reconfigured at that time by software as desired.

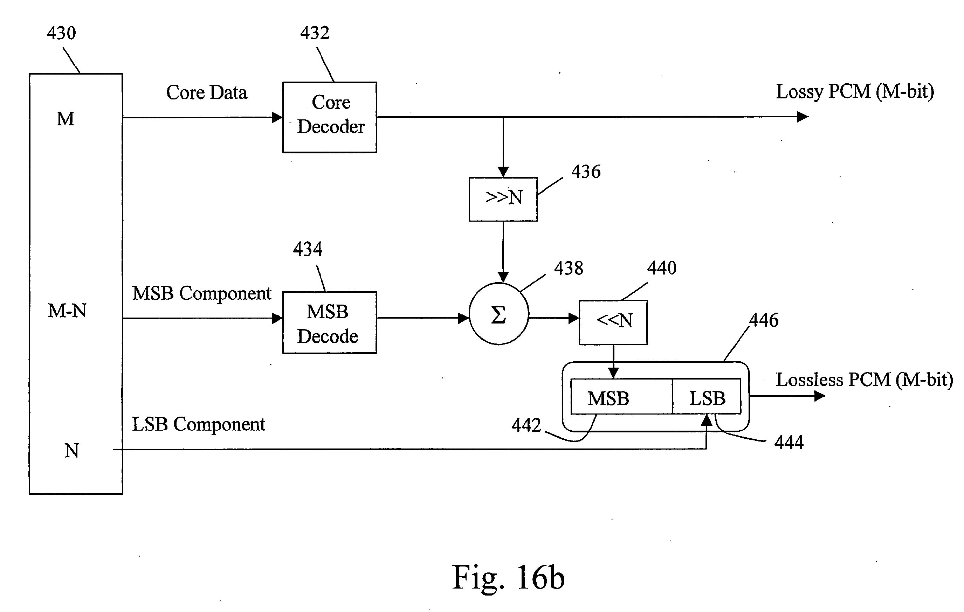

As shown in Figure 16b, the method of decoding is complementary to the method of encoding. A prio r generation decoder can decode the lossy core audio signal by simply decoding the corestream **408** and discarding the lossless MSB and LSB portions. The quality of audio produced in such a prior generation decoder will be extremely good, equivalent to prior generation audio, just not lossless.

Referring now to Figure 16b, the incoming bitstream (recovered from either a transmission channel or a recording medium) is first unpacked in unpacker **430,** which separates the corestream **408** from lossles s extension data streams **418** (LSB) and **426** (MSB). The core stream is decoded by a modified core decoder **432,** which reconstructs the core stream by zeroing out the un - transmitted sub-band samples for the upper 32 bands in a 64-band synthesis during reconstruction. (Note, if a standard core encode was performed, the zeroing out is unnecessary). The MSB extension field is decoded by a lossless MSB decoder **434.** Because the LSB data was losslessly encoded using bit replication no decoding is necessary.

After decoding core and lossless MSB extensions in parallel, with the interpolated core reconstructed data is right shifted by N bits **436** and combined with the lossless portion of the data by adding in summer **438.** The summed output is left shifted by N bits 440 to form the lossless MSB portion **442** and assembled with the N-bit LSB portion **444,** to produce a PCM data word **446** that is a lossless, reconstructed representation of the original audio signal **402.**

Because the signal was encoded by subtracting a decoded, lossy reconstruction from the exact input signal, the reconstructed signal represents an exact reconstruction of the original audio data. Thus, paradoxically, the combination of a lossy codec and a losslessly coded signal actually performs as a pure lossless codec, but with the additional advantage that the encoded data remains compatible with prior generation, lossless decoders. Furthermore, the bitstream can be scaled by selectively discarding LSBs to make it conform to media bit rate constraints and buffer capacity.

While several illustrative embodiments of the invention have been shown and described, numerous variations and alternate embodiments will occur to those skilled in the art. Such variations and alternate embodiments are contemplated, and can be made without departing from the invention as defined in the appended claims.

## Claims

1. A method of encoding and authoring audio data, comprising:
losslessly encoding the audio data in a sequence of analysis windows into a scalable bitstream;
separating the audio data into most significant bit (MSB) and least significant (LSB) portions for each analysis window and encoded with different lossless algorithms by:
assigning a minimum MSB bit width (Min MSB);
assigning a LSB bit width;
comparing a buffered payload for the encoded audio data to an allowed payload for each window;
scaling the losslessly encoded audio data in the non-conforming windows so that the buffered payload for the bitstream does not exceed the allowed payload, said scaling operation introducing loss into the encoded data in those windows-;
wherein assigning the LSB bit width further comprises:
computing a max LSB bit width (Max LSB) as the bit width of the audio data minus Min MSB;
computing an L_{∞} norm as the maximum absolute amplitude of the audio data in the analysis window;
computing Max Amp as the number of bits needed to represent a sample with value equal to - L_{∞};
computing a squared L2 norm as the sum of the squared amplitudes of the audio data in the analysis window;
if Max Amp does not exceed Min MSB and the L2 norm does not exceed a threshold, setting the LSB bit width to zero bits; and
if Max Amp does not exceed Min MSB but the L2 norm doers exceed the threshold, setting the LSB bit width to the Max LSB bit width divided by a scaling factor;
if Max Amp exceeds the Min MSB, setting the LSB bit width to the Max Amp minus Min MSB.

2. The method of claim 1, wherein the LSB bit width is limited to a maximum LSB bit width (Max LSB) determined by a word width of the audio data and Min MSB.

3. The method of claim 1, wherein an LSB bit width and the encoded MSB and LSB portions are packed into a bitstream for each analysis window.

4. The method of claim 1, wherein the MSB portion is encoded with a lossless algorithm that includes decorrelation between multiple audio channels and adaptive prediction within each audio channel.

5. The method of claim 1, wherein the LSB portion is encoded with a lossless algorithm that replicates the bits for the PCM samples.

6. The method of claim 1, wherein the LSB portion is encoded with a lossless algorithm that uses low order prediction and entropy coding.

7. The method of claim 1, wherein the analysis windows are frames, each frame comprising a header for storing the LSB bit widths and one or more segments, each segment comprising one or more channel sets, each channel set comprising one or more audio channels, each channel comprising one or more frequency extensions, said lowest frequency extension including encoded MSB and LSB portions.

8. The method of claim 7, wherein the bitstream has a distinct MSB and LSB split for each channel in each channel set in each frame.

9. The method of claim 7, wherein said higher frequency extensions include only encoded LSB portions.

10. The method of claim 1, wherein, the bitstream is authored by,
Packing the losslessly encoded MSB portions into the bitstream for all the windows;
Packing the losslessly encoded LSB portions into the bitstream for the conforming windows;
Scaling the losslessly encoded LSB portions for any non-conforming windows to make them conform; and
Packing the now lossy encoded LSB portions for the now conforming windows into the bitstream.

11. The method of claim 10, wherein the LSB portions are scaled by,
calculating an LSB bit width reduction for the analysis window;
decoding the LSB portions in the non-conforming windows;
reducing the LSB portions by the LSB bit width reduction by discarding that number of LSBs;
encoding the modified LSB portions with the lossless encoding algorithm;
packing the encoded LSB portions; and
packing the modified LSB bit widths and the LSB bit width reduction into the bitstream.

12. The method of claim 11, wherein the lossless encoding is simple bit replication, wherein the LSB portions are reduced by,
adding dither to each LSB portion so as to dither the next LSB past the LSB bit width reduction; and
shifting the LSB portion to the right by the LSB bit width reduction.

13. The method of claim 11, wherein the LSB bit width reduction is just enough that the buffered payload does not exceed the allowed payload.

14. The method of claim 11, wherein the audio data includes multiple channels, said LSB bit width reduction being calculated for each channel in accordance with a channel prioritization rule.

15. An article of manufacture comprising a bitstream separated into a sequence of analysis windows of encoded audio data stored on a media, the audio data in each said analysis window being losslessly encoded except as necessary to reduce the buffered payload of said analysis window to no more than an allowed payload; wherein some of the analysis windows include losslessly encoded most significant bit (MSB) and least significant bit (LSB) portions and the remaining analysis windows include losslessly encoded MSB portions and lossy encoded LSB portions; wherein the audio data is separated into MSB and LSB portions for each analysis window and encoded with different lossless algorithms by:
assigning a minimum MSB bit width (Min MSB);
assigning a LSB bit width;
wherein assigning the LSB bit width further comprises:
computing a max LSB bit width (Max LSB) as the bit width of the audio data minus Min MSB;
computing an L_{∞} norm as the maximum absolute amplitude of the audio data in the analysis window;
computing Max Amp as the number of bits needed to represent a sample with value equal to - L_{∞};
computing a squared L2 norm as the sum of the squared amplitudes of the audio data in the analysis window;
if Max Amp does not exceed Min MSB and the L2 norm does not exceed a threshold, setting the LSB bit width to zero bits; and
if Max Amp does not exceed Min MSB but the L2 norm does exceed the threshold, setting the LSB bit width to the Max LSB bit width divided by a scaling factor; and
if Max Amp exceeds the Min MSB, setting the LSB bit width to the Max Amp minus Min MSB.

16. The article of manufacture of claim 15, wherein the bitstream includes header information containing the modified bit widths of the LSB portions and the bit width reduction of the LSB portions.

17. The article of manufacture of claim 16, wherein the LSB portions are losslessly and lossy encoded using bit replication.

18. The article of manufacture of claim 17, wherein the bit width reduction of the LSB portions is just enough that the buffered payload does not exceed the allowed payload.

## Patentansprüche

1. Verfahren für Codierung und Authoring von Audiodaten, das umfasst:
verlustloses Codieren der Audiodaten in einer Sequenz von Analyse-Fenstern zu einem skalierbaren Bitstream;
Trennen der Audiodaten in MSB-Abschnitte (most significant bit portions) und LSB-Abschnitte (least significant bit portions) für jedes Analyse-Fenster und Codieren mit unterschiedlichen verlustlosen Algorithmen durch:
Zuweisen einer minimalen MSB-Bitbreite (Min MSB);
Zuweisen einer LBS-Bitbreite;
Vergleichen einer gepufferten Nutzinformation für die codierten Audiodaten mit einer zulässigen Nutzinformation für jedes Fenster;
Skalieren der verlustlos codierten Audiodaten in den nicht übereinstimmenden Fenstern, so dass die gepufferte Nutzinformation für den Bitstream die zulässige Nutzinformation nicht übersteigt, wobei der Skaliervorgang Verlust in den codierten Daten in diesen Fenstern verursacht;
wobei Zuweisen der LSB-Bitbreite des Weiteren umfasst:
Berechnen einer maximalen LSB-Bitbreite (Max LSB) als die Bitbreite der Audiodaten abzüglich Min MSB;
Berechnen einer L_{∞}-Norm als die maximale absolute Amplitude der Audiodaten in dem Analyse-Fenster;
Berechnen von Max Amp als die Anzahl von Bits, die erforderlich ist, um ein Sample mit einem Wert darzustellen, der gleich -L_{∞} ist;
Berechnen einer quadrierten L2-Norm als die Summe der quadrierten Amplituden der Audiodaten in dem Analyse-Fenster;
wenn Max Amp Min MSB nicht übersteigt und die L2-Norm einen Schwellenwert nicht übersteigt, Setzen der LSB-Bitbreite auf 0 Bits; und
wenn Max Amp Min MSB nicht übersteigt, die L2-Norm jedoch den Schwellenwert übersteigt, Setzen der LSB-Bitbreite auf die Max-LSB-Bitbreite, dividiert durch einen Skalierfaktor;
wenn Max Amp Min MSB übersteigt, Setzen der LSB-Bitbreite auf Max Amp abzüglich Min MSB.

2. Verfahren nach Anspruch 1, wobei die LSB-Bitbreite auf eine maximale LSB-Bitbreite (Max LSB) begrenzt ist, die durch eine Wordbreite der Audiodaten und Min MSB bestimmt wird.

3. Verfahren nach Anspruch 1, wobei eine LSB-Bitbreite und die codierten MSB- und LSB-Abschnitte zu einem Bitstream für jedes Analyse-Fenster gepackt werden.

4. Verfahren nach Anspruch 1, wobei der MSB-Abschnitt mit einem verlustlosen Algorithmus codiert ist, der Dekorrelation zwischen mehreren Audiokanälen und adaptive Prädiktion innerhalb jedes Audiokanals einschließt.

5. Verfahren nach Anspruch 1, wobei der LSB-Abschnitt mit einem verlustlosen Algorithmus codiert ist, der die Bits für die PCM-Samples dupliziert.

6. Verfahren nach Anspruch 1, wobei der LSB-Abschnitt mit einem verlustlosen Algorithmus codiert ist, der Prädiktion niedriger Ordnung und Entropiecodierung verwendet.

7. Verfahren nach Anspruch 1, wobei das Analyse-Fenster aus Frames besteht, jeder Frame einen Header zum Speichern der LSB-Bitbreiten und eines oder mehrere Segmente umfasst, wobei jedes Segment eine oder mehrere Kanalgruppe/n umfasst und jede Kanalgruppe einen oder mehrere Audiokanal/kanäle umfasst, jeder Kanal eine oder mehrere Frequenzerweiterung/en umfasst und die niedrigste Frequenzerweiterung codierte MSB- und LSB-Abschnitte enthält.

8. Verfahren nach Anspruch 7, wobei der Bitstream eine separate MSB- und LSB-Teilung für jeden Kanal in jeder Kanalgruppe in jedem Frame aufweist.

9. Verfahren nach Anspruch 7, wobei die höheren Frequenzerweiterungen nur codierte LSB-Abschnitte enthalten.

10. Verfahren nach Anspruch 1, wobei Authoring des Bitstreams durchgeführt wird, indem:
die verlustlos codierten MSB-Abschnitte in den Bitstream für alle Fenster gepackt werden;
die verlustlos codierten LSB-Abschnitte in den Bitstream für die übereinstimmenden Fenster gepackt werden;
die verlustlos codierten LSB-Abschnitte für etwaige nicht übereinstimmende Fenster skaliert werden, um Übereinstimmung derselben herzustellen; und
die nunmehr verlustbehaftet codierten LSB-Abschnitte für die nunmehr übereinstimmenden Fenster in den Bitstream gepackt werden.

11. Verfahren nach Anspruch 10, wobei die LSB-Abschnitte skaliert werden, indem:
eine LSB-Bitbreiten-Verringerung für das Analyse-Fenster berechnet wird;
die LSB-Abschnitte in den nicht übereinstimmenden Fenstern decodiert werden;
die LSB-Abschnitte um die LSB-Bitbreitenverringerung verringert werden, indem diese Anzahl von LSB verworfen wird;
die modifizierten LSB-Abschnitte mit dem verlustlosen Codieralgorithmus codiert werden;
die codierten LSB-Abschnitte gepackt werden; und
die modifizierten LSB-Bitbreiten und die LSB-Bitbreitenverringerung in den Bitstream gepackt werden.

12. Verfahren nach Anspruch 11, wobei das verlustlose Codieren einfache Duplizierung ist und die LSB-Abschnitte reduziert werden, indem:
Dither zu jedem LSB-Abschnitt hinzugefügt wird, um so Dithering des nächsten LSB über die LSB-Bitbreiten-Reduzierung durchzuführen; und
Verschieben des LSB-Abschnitts nach rechts um die LSB-Bitbreiten-Reduzierung.

13. Verfahren nach Anspruch 11, wobei die LSB-Bitbreiten-Reduzierung gerade ausreicht, um zu verhindern, dass die gepufferte Nutzinformation die zulässige Nutzinformation übersteigt.

14. Verfahren nach Anspruch 11, wobei die Audiodaten mehrere Kanäle enthalten und die LSB-Bitbreiten-Reduzierung für jeden Kanal entsprechend einer Kanal-Priorisierungsregel berechnet wird.

15. Erzeugnis, das einen Bitstream umfasst, der in eine Sequenz von Analyse-Fenster codierter Audiodaten getrennt ist und auf einem Medium gespeichert ist, wobei die Audiodaten in jedem der Analyse-Fenster bis auf das zum Reduzieren der gepufferten Nutzinformation des Analyse-Fensters auf nicht mehr als eine zulässige Nutzinformation erforderliche Maß verlustlos codiert sind und einige der Analyse-Fenster verlustlos codierte MSB-Abschnitte (most significant bit portions) sowie LSB-Abschnitte (least significant bit portions) enthalten und die verbleibenden Analyse-Fenster verlustlos codierte MSB-Abschnitte sowie verlustbehaftet codierte LSB-Abschnitte enthalten und die Audiodaten in MSB- und LSB-Abschnitte für jedes Analyse-Fenster getrennt und mit unterschiedlichen verlustlosen Algorithmen codiert werden, indem:
eine minimale MSB-Bitbreite (Min MSB) zugewiesen wird;
eine LSB-Bitbreite zugewiesen wird;
wobei Zuweisen der LSB-Bitbreite des Weiteren umfasst:
Berechnen einer maximalen LSB-Bitbreite (Max LSB) als die Bitbreite der Audiodaten abzüglich Min MSB;
Berechnen einer L_{∞}-Norm als die maximale absolute Amplitude der Audiodaten in dem Analyse-Fenster;
Berechnen von Max Amp als die Anzahl von Bits, die erforderlich ist, um ein Sample mit einem Wert darzustellen, der gleich -L_{∞} ist;
Berechnen einer quadrierten L2-Norm als die Summe der quadrierten Amplituden der Audiodaten in dem Analyse-Fenster;
wenn Max Amp Min MSB nicht übersteigt und die L2-Norm einen Schwellenwert nicht übersteigt, Setzen der LSB-Bitbreite auf 0 Bits; und
wenn Max Amp Min MSB nicht übersteigt, die L2-Norm jedoch den Schwellenwert übersteigt, Setzen der LSB-Bitbreite auf die Max-LSB-Bitbreite, dividiert durch einen Skalierfaktor;
wenn Max Amp Min MSB übersteigt, Setzen der LSB-Bitbreite auf Max Amp abzüglich Min MSB.

16. Erzeugnis nach Anspruch 15, wobei der Bitstream Header-Informationen enthält, die die modifizierten Bitbreiten der LSB-Abschnitte und die Bitbreiten-Reduzierung der LSB-Abschnitte beinhalten.

17. Erzeugnis nach Anspruch 16, wobei die LSB-Abschnitte unter Verwendung von Bit-Duplizierung verlustlos und verlustbehaftet codiert werden.

18. Erzeugnis nach Anspruch 17, wobei die Bitbreiten-Reduzierung der LSB-Abschnitte gerade ausreicht, um zu verhindern, dass die gepufferte Nutzinformation die zulässige Nutzinformation übersteigt.

## Revendications

1. Procédé de codage et de création de données audio, comprenant les étapes consistant à :
coder sans perte les données audio dans une séquence de fenêtres d'analyse en un train de bits modulable ;
séparer les données audio en portions de bits les plus significatifs (MSB) et les moins significatifs (LSB) pour chaque fenêtre d'analyse et codées avec différents algorithmes sans perte par les étapes consistant à :
affecter une largeur de bit MSB minimale (Min MSB) ;
affecter une largeur de bit LSB ;
comparer une charge utile en mémoire tampon pour les données audio codées à une charge utile autorisée pour chaque fenêtre ;
mettre à l'échelle les données audio codées sans perte dans les fenêtres non conformes de sorte que la charge utile en mémoire tampon pour le train de bits ne dépasse pas la charge utile autorisée, ladite opération de mise à l'échelle introduisant une perte dans les données codées dans ces fenêtres ;
dans lequel l'affectation de la largeur de bit LSB comprend en outre les étapes consistant à :
calculer une largeur de bit LSB maximale (Max LSB) comme la largeur de bit des données audio moins Min MSB ;
calculer une norme L_{∞} comme l'amplitude absolue maximale des données audio dans la fenêtre d'analyse ;
calculer Max Amp comme le nombre de bits nécessaires pour représenter un échantillon d'une valeur égale à -L_{∞} ;
calculer une norme L2 au carré comme la somme des amplitudes au carré des données audio dans la fenêtre d'analyse ;
si Max Amp ne dépasse pas Min MSB et la norme L2 ne dépasse pas un seuil, régler la largeur de bit LSB sur zéro bits ; et
si Max Amp ne dépasse pas Min MSB mais la norme L2 dépasse le seuil, régler la largeur de bit LSB sur la largeur de bit Max LSB divisée par un facteur de mise à l'échelle ;
si Max Amp dépasse Min MSB, régler la largeur de bit LSB sur Max Amp moins Min MSB.

2. Procédé selon la revendication 1, dans lequel la largeur de bit LSB est limitée à une largeur de bit LSB maximale (Max LSB) déterminée par une largeur de mot des données audio et Min MSB.

3. Procédé selon la revendication 1, dans lequel une largeur de bit LSB et les portions MSB et LSB codées sont comprimées en un train de bits pour chaque fenêtre d'analyse.

4. Procédé selon la revendication 1, dans lequel la portion MSB est codée par un algorithme sans perte qui comprend une décorrélation entre plusieurs canaux audio et une prédiction adaptative à l'intérieur de chaque canal audio.

5. Procédé selon la revendication 1, dans lequel la portion LSB est codée par un algorithme sans perte qui reproduit les bits pour les échantillons PCM.

6. Procédé selon la revendication 1, dans lequel la portion LSB est codée par un algorithme sans perte qui utilise une prédiction d'ordre inférieur et un codage entropique.

7. Procédé selon la revendication 1, dans lequel les fenêtres d'analyse sont des trames, chaque trame comprenant un en-tête pour stocker les largeurs de bit LSB et un ou plusieurs segments, chaque segment comprenant un ou plusieurs ensembles de canaux, chaque ensemble de canaux comprenant un ou plusieurs canaux audio, chaque canal comprenant une ou plusieurs extensions de fréquence, ladite extension de fréquence la plus basse comprenant des portions MSB et LSB codées.

8. Procédé selon la revendication 7, dans lequel le train de bits présente un fractionnement distinct des MSB et LSB pour chaque canal dans chaque ensemble de canaux dans chaque trame.

9. Procédé selon la revendication 7, dans lequel lesdites extensions de fréquence supérieures comprennent uniquement des portions LSB codées.

10. Procédé selon la revendication 1, dans lequel le train de bits est créé par les étapes consistant à :
comprimer les portions MSB codées sans perte dans le train de bits pour toutes les fenêtres ;
comprimer les portions LSB codées sans perte dans le train de bits pour les fenêtres conformes ;
mettre à l'échelle les portions LSB codées sans perte pour toutes les fenêtres non-conformes afin de les rendre conformes ; et
comprimer les portions LSB à présent codées avec perte pour les fenêtres à présent conformes dans le train de bits.

11. Procédé selon la revendication 10, dans lequel les portions LSB sont mises à l'échelle par les étapes consistant à :
calculer une réduction de largeur de bit LSB pour la fenêtre d'analyse ;
décoder les portions LSB dans les fenêtres non conformes ;
réduire les portions LSB par la réduction de largeur de bit LSB en abandonnant ce nombre de LSBs ;
coder les portions LSB modifiées par l'algorithme de codage sans perte ;
comprimer les portions LSB codées ; et
comprimer les largeurs de bit LSB codées et la réduction de largeur de bit LSB dans le train de bits.

12. Procédé selon la revendication 11, dans lequel le codage sans perte est une simple reproduction binaire, dans lequel les portions LSB sont réduites par les étapes consistant à :
ajouter un signal de superposition à chaque portion LSB de façon à superposer un signal au LSB suivant au-delà de la réduction de largeur de bit LSB ; et
décaler la portion LSB à droite de la réduction de largeur de bit LSB.

13. Procédé selon la revendication 11, dans lequel la réduction de largeur de bit LSB est tout juste suffisante pour que la charge utile en mémoire tampon ne dépasse pas la charge utile autorisée.

14. Procédé selon la revendication 11, dans lequel les données audio comprennent plusieurs canaux, ladite réduction de largeur de bit LSB étant calculée pour chaque canal selon une règle de priorisation de canal.

15. Objet manufacturé, comprenant un train de bits séparé en une séquence de fenêtres d'analyse de données audio codées, stockées sur un support, les données audio dans chaque dite fenêtre d'analyse étant codées sans perte, excepté comme nécessaire pour réduire la charge utile en mémoire tampon de ladite fenêtre d'analyse à pas plus d'une charge utile autorisée ; dans lequel certaines des fenêtres d'analyse comprennent des portions codées sans perte de bits les plus significatifs (MSB) et de bits les moins significatifs (LSB), et les fenêtres d'analyse restantes comprennent des portions MSB codées sans pertes et des portions LSB codées avec perte ; dans lequel les données audio sont séparées en portions MSB et LSB pour chaque fenêtre d'analyse et codées par différents algorithmes sans perte par les étapes consistant à :
affecter une largeur de bit MSB minimale (Min MSB) ;
affecter une largeur de bit LSB ;
dans lequel l'affectation de la largeur de bit LSB comprend en outre les étapes consistant à :
calculer une largeur de bit LSB maximale (Max LSB) comme la largeur de bit des données audio moins Min MSB ;
calculer une norme L_{∞} comme l'amplitude absolue maximale des données audio dans la fenêtre d'analyse ;
calculer Max Amp comme le nombre de bits nécessaires pour représenter un échantillon d'une valeur égale à -L_{∞} ;
calculer une norme L2 au carré comme la somme des amplitudes au carré des données audio dans la fenêtre d'analyse ;
si Max Amp ne dépasse pas Min MSB et la norme L2 ne dépasse pas un seuil, régler la largeur de bit LSB sur zéro bits ; et
si Max Amp ne dépasse pas Min MSB mais la norme L2 dépasse le seuil, régler la largeur de bit LSB sur la largeur de bit Max LSB divisée par un facteur de mise à l'échelle ; et
si Max Amp dépasse Min MSB, régler la largeur de bit LSB sur Max Amp moins Min MSB.

16. Objet manufacturé selon la revendication 15, dans lequel le train de bits comprend des informations d'en-tête contenant les largeurs de bit modifiées des portions LSB et la réduction de largeur de bit des portions LSB.

17. Objet manufacturé selon la revendication 16, dans lequel les portions LSB sont codées sans et avec perte en utilisant une reproduction binaire.

18. Objet manufacturé selon la revendication 17, dans lequel la réduction de largeur de bit des portions LSB est tout juste suffisante pour que la charge utile en mémoire tampon ne dépasse pas la charge utile autorisée.
